# EUROPÄISCHE PATENTANMELDUNG

(11) **EP 3 996 277 A1**
(43) Veröffentlichungstag der Anmeldung: **11.05.2022**
(21) Anmeldenummer: 20205908.5
(22) Anmeldetag: 05.11.2020
(51) Int. Cl.: H03K 17/51, H01H 59/00, H01H 1/00

(54) **SCHALTUNGSANORDNUNG FÜR EINEN DIGITALEINGANG UND ELEKTRONISCHES GERÄT AUSGESTALTET ALS EINE DIGITALE EINGABEBAUGRUPPE**

(71) Anmelder: Siemens Aktiengesellschaft, 80333 München (DE)
(72) Erfinder: Fischer, Peter, 92421 Schwandorf (DE); Raab, Oliver, 94496 Ortenburg (DE); Ernst, Wolfgang, 92245 Kümmersbruck (DE); Happel, Christian, 92245 Kümmersbruck (DE); Reiss, Herbert, 92256 Hahnbach (DE); Schwarz, Markus, 80796 München (DE); Wilke, Hans, 85599 Parsdorf (DE)

(57) **Zusammenfassung**

Die Erfindung betrifft eine Schaltungsanordnung (1) für einen Digitaleingang eines elektronischen Gerätes (30), umfassend
- einen als Digitaleingang fungierenden Eingangsanschluss (10) auf einer Eingangsseite (E),
- einen als Signalausgang fungierenden Ausgangsanschluss (11) auf einer Ausgangsseite (A),
- ein Schaltelement, welches ausgestaltet ist, ein auf der Eingangsseite (E) erkanntes Signal (S) an die Ausgangsseite (A) zur Weiterverarbeitung weiter zu leiten,
- einen Masseanschluss (M), wobei zwischen dem Eingangsanschluss (10) und dem Masseanschluss (M) eine Halbleiteranordnung (Q) zur Strombegrenzung eines Eingangsstroms (Iᵢₙ) für das Schaltelement angeordnet ist, wobei die Halbleiteranordnung (Q) zusätzlich ausgestaltet ist eine Höhe einer Spannung (U) des Signals an dem Eingangsanschluss (10) anhand einer ersten Schalschwelle (LP) als logisch Null zu werten und anhand einer zweiten Schaltschwelle (HP) als logisch Eins zu werten,
wobei das Schaltelement als ein mikroelektromechanischer Schalter (MEMS) mit einem auslenkbar angeordnetem Haupt-Schaltbalken (HS) ausgestaltet ist,
wobei der mikroelektromechanische Schalter (MEMS) hinsichtlich einer Geometrie des Haupt-Schaltbalkens (HS) ausgestaltet ist, dass der Haupt-Schaltbalken (HS) erst ausgelenkt wird, wenn die Spannung am Eingangsanschluss (10) die zweite Schaltschwelle (LH) überschreitet.

## Beschreibung

Die Erfindung betrifft eine Schaltungsanordnung für einen Digitaleingang eines elektronischen Gerätes, umfassend einen als Digitaleingang fungierenden Eingangsanschluss auf einer Eingangsseite, einen als Signalausgang fungierenden Ausgangsanschluss auf einer Ausgangsseite, ein Schaltelement, welches ausgestaltet ist ein auf der Eingangsseite erkanntes Signal an die Ausgangsseite zur Weiterverarbeitung weiterzuleiten, einen Masseanschluss, wobei zwischen dem Eingangsanschluss und dem Masseanschluss eine Halbleiteranordnung zur Strombegrenzung eines Eingangsstroms für das Schaltelement angeordnet ist, wobei die Halbleiteranordnung zusätzlich ausgestaltet ist, eine Höhe einer Spannung des Signals an dem Eingangsanschluss anhand einer ersten Schaltschwelle als logisch Null zu werten und anhand einer zweiten Schaltschwelle als logisch Eins zu werten.

Des Weiteren betrifft die Erfindung ein elektronisches Gerät ausgestaltet als eine digitale Eingabebaugruppe für ein Automatisierungsgerät, welche oben genannte Schaltungsanordnung aufweist.

Als digitale Eingabebaugruppe für ein Automatisierungsgerät wird insbesondere eine Peripheriebaugruppe verstanden. Im Sinne der Erfindung wird ein elektronisches Gerät als Baugruppe oder als Modul für ein Automatisierungsgerät bezeichnet, dass zum Anschluss einer externen Peripherie, also z.B. Sensoren bestimmt und vorgesehen ist.

Automatisierungsgeräte der eingangs genannten Art, insbesondere in einer Ausführungsform als modulare Automatisierungsgeräte, sind allgemein bekannt, z.B. in Form der Automatisierungsgeräte, die von der Anmelderin unter der Marke Simatic angeboten werden. Aus dieser Palette an Automatisierungsgeräten sind auch als Einzelmodule ausgeführte digitale Eingabebaugruppen bekannt.

Die Erfindung bezieht sich speziell auf eine Schaltungsanordnung mit mindestens einen als Digitaleingang fungierenden Eingangsanschluss für eine Eingabebaugruppe. Bei einer solchen Schaltungsanordnung bzw. bei einer solchen Baugruppe handelt es sich entsprechend um eine Peripheriebaugruppe mit einer Digitaleingabe-Funktionalität, solche Baugruppen werden häufig mit einer Mehrzahl, z.B. 16 oder 32 Digitaleingängen ausgeführt und entsprechend als Digitaleingabebaugruppe bezeichnet.

Aktuell werden derartige Digitaleingänge bzw. die Schaltungsanordnungen dafür mit Hilfe von Optokopplern und diskreten Transistoren sowie weiteren passiven Bauteilen wie Dioden, Widerständen und Kondensatoren aufgebaut. Nachteilig an diesem diskreten Aufbau ist, dass die Bauteile relativ viel Bauraum einnehmen. Ein weiterer Nachteil ist, dass man bei einem Einsatz von Optokopplern in der Schaltungsanordnung in der Regel einen zusätzlichen Versorgungsanschluss für einen aktiven Optokoppler benötigt. Eine derzeitige Kunden- bzw. Marktanforderung ist es aber, auf einen zusätzlichen Versorgungsanschluss zu verzichten. Dies hat zur Folge, dass nur Optokoppler ohne eigene Versorgungsspannung verwendet werden können und somit weitreichende Anforderungen an eine Übertragungsgeschwindigkeit und Jitter nicht bedient werden können. Mit bereits verfügbaren, integrierten Optokoppler-Lösungen können die genannten Anforderungen an Übertragungsgeschwindigkeit und Jitter nur erfüllt werden, wenn diese bekannten Schaltungsanordnungen auf der Eingangsseite mit Spannung versorgt werden. Aber ein zusätzlicher Versorgungsanschluss an einer Digitaleingabebaugruppe ist zum einen nicht gewünscht und führt zu einer Inkompatibilität gegenüber den heutigen, diskreten Lösungen und zusätzlich zu einem erhöhten Verdrahtungsaufwand bei einem Kunden.

Des Weiteren wird der Optokoppler als eine galvanische Trennung eingesetzt. Eine galvanische Trennung ist notwendig, wenn Stromkreise zwar aufeinander einwirken sollen, ihre Bezugspotentiale jedoch getrennt bleiben sollen. Dies kann zur Vermeidung von Störungen, wie "Gleichtakt-Störungen" oder "Ausgleichsströme über Erdschleifen", z.B. bei der Übergabe von Messsignalen, Hochfrequenz- oder Audiosignalen oder bei der Weiterleitung von digitalen Signalen, erforderlich sein.

Es ist Aufgabe der vorliegenden Erfindung, eine Schaltungsanordnung für eine Digitaleingabebaugruppe bereitzustellen, mit welcher die hohen Anforderungen an eine Übertragungsgeschwindigkeit und einen Jitter erfüllt werden können, wobei jedoch auf einen zusätzlichen Versorgungsspannungsanschluss verzichtet werden kann.

Die Aufgabe wird für die eingangs genannte Schaltungsanordnung dadurch gelöst, dass das Schaltelement als ein mikroelektromechanischer Schalter mit einem auslenkbar angeordnetem Haupt-Schaltbalken ausgestaltet ist, wobei der mikroelektromechanische Schalter hinsichtlich einer Geometrie des Haupt-Schaltbalkens ausgestaltet ist, dass der Haupt-Schaltbalken erst ausgelenkt wird, wenn die Spannung am Eingangsanschluss die zweite Schaltschwelle überschreitet.

Mit dem Einsatz eines mikroelektromechanischen Schalters hat man nun eine Schaltungsanordnung für einen "schnellen" Digitaleingang geschaffen. Sogenannte "High Feature" Eingaben können nun die oben genannten Anforderungen hinsichtlich Verzögerungszeit und Jitter erfüllen. Diese Anforderungen waren zuvor nur mit Optokopplern oder integrierten Lösungen möglich, wenn diese mit einer zusätzlichen Versorgungsspannung auf der Eingabeseite versehen wurden. Die vorgestellte Lösung auf der Basis eines mikroelektromechanischen Schalters, insbesondere eines SOI-MEMS-Schalter, ermöglich somit eine integrierte Lösung, welche die geringen Fertigungskosten einer heutigen Basisbaugruppe erreicht bzw. unterschreitet, aber die technischen Anforderungen einer HF-Eingabebaugruppe hinsichtlich Verzögerungszeit und Jitter erfüllt und weiterhin keinen Versorgungsspannungsanschluss auf der Digitaleingabeseite benötigt.

Eine weitere Ausgestaltungsvariante sieht vor, dass der mikroelektromechanische Schalter mit zumindest einem auslenkbar angeordneten ersten Hilfs-Schaltbalken ausgestaltet ist, welcher hinsichtlich seiner Geometrie ausgestaltet ist, dass der erste Hilfs-Schaltbalken bereits ausgelenkt wird, wenn die Spannung am Eingangsanschluss die erste Schaltschwelle überschreitet.

Der zusätzliche Hilfs-Schaltbalken kann bei einer später erweiterten Schaltungsanordnung für eine zusätzliche Funktionalität, insbesondere eine Drahtbruchprüfung, mitbenutzt werden.

Bei einer Ausgestaltung der Schaltungsanordnung, wobei der mikroelektromechanische Schalter mit einer Mehrzahl auslenkbar angeordneter Hilfs-Schaltbalken ausgestaltet ist und die Hilfs-Schaltbalken hinsichtlich ihrer Geometrien derart ausgestaltet sind, dass die Spannungswerte bei welchen die Hilfs-Schaltbalken ausgelenkt werden, eine Schalt-Hysterese beschreiben, um Spannungsschwankungen der Spannungen am Eingangsanschluss zu unterdrücken, welche die zweite Schaltschwelle als logisch Eins betrifft.

Mit der Ausgestaltung mit mehreren Hilfs-Schaltbalken und der Nachbildung einer Hysterese kann auf vorteilhafte Weise bei Eingangsspannungs-Schwankungen am Digitaleingang einem unzulässigen Wegschalten des logischen Eins Signals entgegengewirkt werden, weil in einem gewissen Spannungsbereich mit einer zusätzlichen Funktionalität immer noch sicher ein Eins Signal über, mittels Schaltbalken mit den zugeordneten Hysterese-Werten, erkannt wird.

Bezogen auf die zusätzliche Funktionalität einer Drahtbrucherkennung weist die Schaltungsanordnung eine Drahtbrucherkennungseinheit auf, welche ausgestaltet ist ein Drahtbruchsignal zu erzeugen, wenn weder der Haupt-Schaltbalken noch der Hilfs-Schaltbalken ausgelenkt ist. Vorzugsweise ist der mikroelektromechanische Schalter hinsichtlich der Geometrien der Schaltbalken derart ausgeführt, dass eine Pull-in Spannung für den Haupt-Schaltbalken der gewünschten Schaltspannung des Digitaleingangs entspricht. Es ist daher auch denkbar, zusätzliche Schaltbalken mit unterschiedlichen Geometrien anzuordnen diese zu verschalten und z.B. mit zusätzlichen Logikgattern Warengrenzen (Drahtbruch) oder Hysteresen zu realisieren.

Insbesondere für die Realisierung der Drahtbrucherkennung wird ausgehend von einer ersten Schaltschwelle, welche als logisch Null gewertet wird, und einer zweiten Schaltschwelle, welche als logisch Eins gewertet wird, der erste Hilfs-Schaltbalken derart ausgestaltet ist, dass er bei einer Spannung am Eingangsanschluss, welche die erste Schaltschwelle überschreitet, ausgelenkt wird. Das Überschreiten der ersten Schaltschwelle heißt allerdings noch, dass eine logische Null am Eingangsanschluss anliegt. Aber es hat sich in der industriellen Automatisierungstechnik etabliert, einen relativ hochohmigen Widerstand parallel zu einem Geberkontakt für das Signal auf der Eingangsseite zu schalten. Das bedeutet, dass trotz geöffneten Geberkontaktes immer ein gewisser Strom fließt und somit eine gewisse untere Schaltschwelle erreicht wird. Sollte diese untere gewisse Schaltschwelle nicht mehr vorhanden sein, wird dementsprechend auch nicht der Hilfs-Schaltbalken ausgelenkt und dies ist ein sicheres Zeichen dafür, dass ein Drahtbruch vorliegt.

Als besonders vorteilhaft wird angesehen, wenn die Schaltungsanordnung derart ausgestaltet ist, dass die Halbleiteranordnung und der mikroelektromechanische Schalter als ein monolithischer Schaltkreis zusammengefasst sind. Nun hat man mit Vorteil, einen integrierten Schaltkreis, welcher zum einen einen MEMS-basierten Schalter realisiert und zum anderen die Halbleiteranordnung integriert hat. Halbleiterbauteile, wie z.B. die Dioden, der Transistor und auch die Widerstände werden monolithisch auf dem Silizium eines MEMS-Schalters integriert.

Bei einer Aufbauvariante der Schaltungsanordnung hat es sich als vorteilhaft herausgestellt, dass der monolithische Schaltkreis als ein hermetisch abgeschlossenes Gehäuse ausgestaltet ist und der mikroelektromechanische Schalter aufgebaut ist, mit einem Glasdeckel-Wafer, einer Schaltschicht auf einer Isolierschicht, welche auf einer Tragschicht liegt, wobei die Schaltschicht zumindest den Haupt-Schaltbalken aufweist, und die Halbleiteranordnung in das Gehäuse integriert ist.

Bezogen auf eine Peripheriebaugruppe in der Automatisierungstechnik wird die eingangs genannte Aufgabe durch ein elektronisches Gerät gelöst, welches ausgestaltet ist, als eine digitale Eingabebaugruppe für ein Automatisierungsgerät mit einer Schaltungsanordnung nach einem der Ansprüche 1 bis 7.

Das elektronische Gerät mit der vorteilhaften Funktionalität einer Drahtbrucherkennung ist vorzugsweise ausgestaltet, als eine digitale Eingabebaugruppe für ein Automatisierungsgerät mit einer Schaltungsanordnung nach Anspruch 4, wobei die Drahtbrucherkennungseinheit derart konfiguriert ist, dass das Drahtbruchsignal dadurch generiert wird, dass der Hilfs-Schaltbalken nicht ausgelenkt wird, und kein Drahtbruchsignal generiert wird, wenn aufgrund eines Parallelwiderstandes, welcher parallel zu einem Geberkontakt für das Signal auf der Eingangsseite geschaltet ist, wobei der erste Hilfs-Schaltbalken ausgelenkt wird, wenn der Geberkontakt zwar geöffnet ist, aber die Spannung am Eingangsanschluss aufgrund des Stromes durch den Parallelwiderstand die erste Schaltschwelle überschreitet.

Im Sinne der Erfindung wird unter einen MEMS-Schalter in der Regel ein Dreipol-Schalter mit "Source", "Gate" und "Drain" verstanden. Sobald eine Gleichspannung an das Gate des Schalters angelegt wird, wird auf die Schaltbalken eine elektrostatische Zugkraft ausgeübt, steigt die Gate-Spannung auf einen ausreichend hohen Wert, überwindet die Zugkraft ein gewisses Moment, beispielsweise einer Feder und ein Schaltkontakt berührt einen der Kontakte der Gate-Anschlüsse.

Dadurch wird eine Verbindung zwischen Source und Drain geschlossen und der Schalter ist jetzt eingeschaltet. Sobald die Gate-Spannung abgeschaltet wird, verschwindet die elektrostatische Anziehungskraft und das Schaltelement verhält sich wie eine Feder mit genügend Rückstellkraft zum Öffnen der Verbindung zwischen Source und Drain. Der Schalter gelangt so in seine ursprüngliche, ausgestaltete Position.

Anhand der Zeichnung werden Ausführungsbeispiele aufgezeigt. Es zeigen
- FIG 1: eine Schaltungsanordnung für einen Digitaleingang,
- FIG 2: unterschiedliche Schaltschwellen für eine logische Null und eine logische Eins,
- FIG 3: eine Detaildarstellung eines mikroelektromechanischen Schalters mit einem Haupt-Schaltbalken und einem Hilfs-Schaltbalken,
- FIG 4: eine mögliche Ausgestaltung für eine Hystereseeinheit,
- FIG 5: unterschiedliche Geometrien für Haupt-Schaltbalken und Hilfs-Schaltbalken,
- FIG 6: minimale Schaltspannungen bzw. Gate-Spannungen für die in FIG 5 gezeigten Geometrien,
- FIG 7: ein elektronisches Gerät bzw. eine Peripheriebaugruppe,
- FIG 8: den Aufbau eines mikroelektromechanischen Schalters in einem hermetischen Gehäuse,
- FIG 9: eine erste Ausführungsvariante einer Integration der Halbleiteranordnung in das Gehäuse,
- FIG 10: eine zweite Ausführungsvariante einer Integration der Halbleiteranordnung in das Gehäuse,
- FIG 11: eine dritte Ausführungsvariante,
- FIG 12: eine vierte Ausführungsvariante und
- FIG 13: eine fünfte Ausführungsvariante.

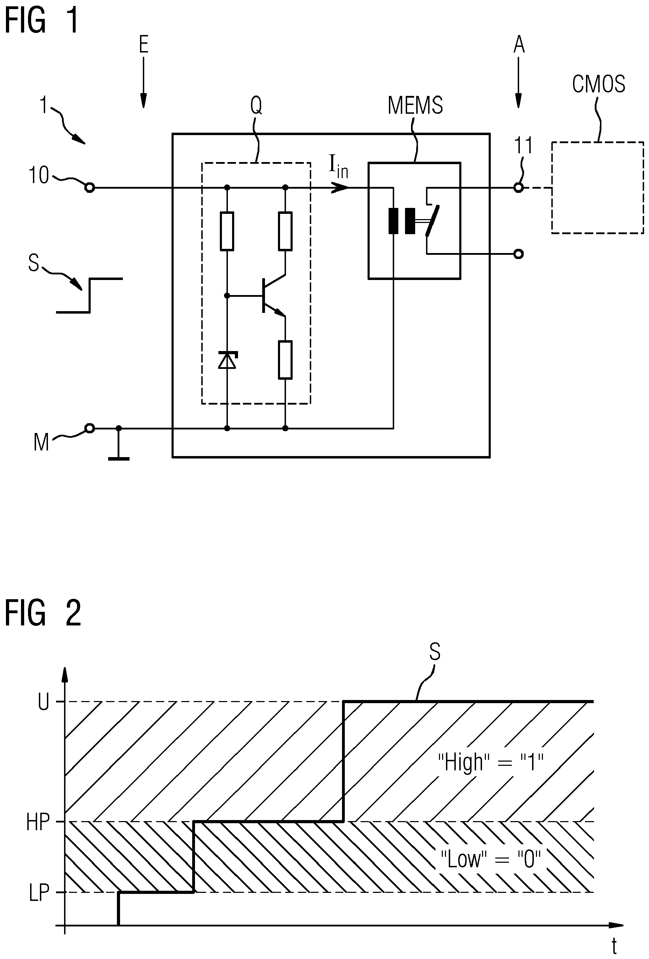

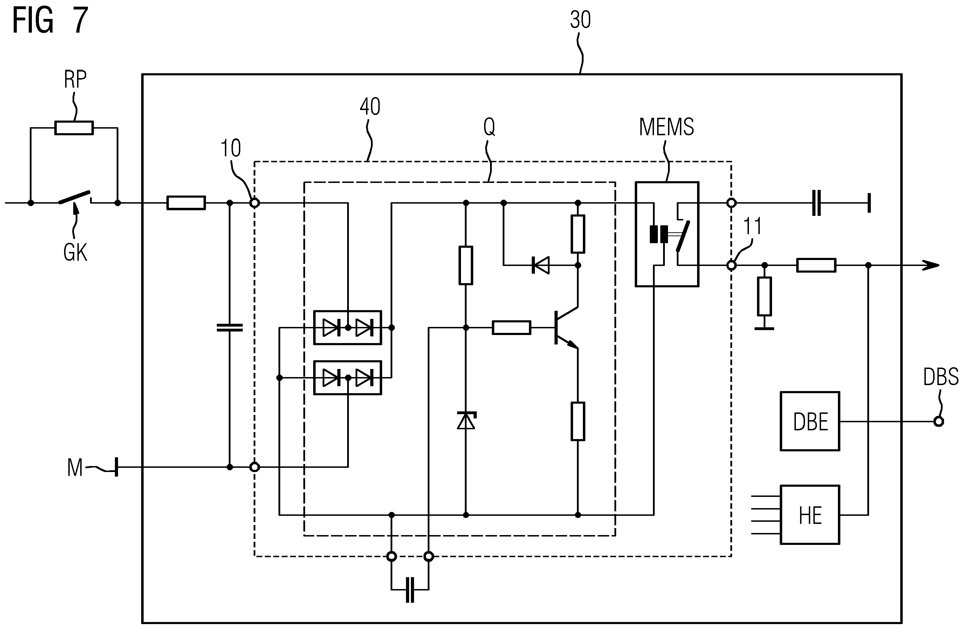

Gemäß FIG 1 ist eine Schaltungsanordnung 1 für einen Digitaleingang eines elektronischen Gerätes 30 (siehe FIG 7) dargestellt. Ein Eingangsanschluss 10 auf einer Eingangsseite E fungiert als der Digitaleingang. Ein Ausgangsanschluss 11 auf einer Ausgangsseite A fungiert als ein Signalausgang. Die Schaltungsanordnung 1 weist ein Schaltelement auf, welches ausgestaltet ist, ein auf der Eingangsseite E erkanntes Signal S an die Ausgangsseite A zur Weiterverarbeitung weiterzuleiten. Nach dem Stand der Technik war das Schaltelement in der Regel als ein Optokoppler ausgestaltet.

Auf der Eingangsseite E steht des Weiteren ein Masseanschluss M zur Verfügung, wobei zwischen dem Eingangsanschluss 10 und dem Masseanschluss M eine Halbleiteranordnung Q zur Strombegrenzung eines Eingangsstromes Iᵢₙ für das Schaltelement angeordnet ist. Die Halbleiteranordnung Q kann als ein Spannungsteiler in einer Transistor-Basisschaltung mit einer Z-Diode ausgestaltet sein, um im Wesentlichen eine bestimmte Eingangsspannung und eine Strombegrenzung bereitzustellen.

Die Halbleiteranordnung Q ist demnach ausgestaltet, die Höhe einer Spannung U des Signals S an den Eingangsanschluss 10 anhand einer ersten Schaltschwelle LP als logisch Null auszuwerten und anhand einer zweiten Schaltschwelle HP als logisch Eins auszuwerten (siehe hierzu FIG 2).

Erfindungsgemäß ist das Schaltelement als ein mikroelektromechanischer Schalter MEMS mit einem auslenkbar angeordneten Haupt-Schaltbalken HS ausgestaltet. Der mikroelektromechanische Schalter MEMS ist hinsichtlich einer Geometrie des Haupt-Schaltbalkens HS ausgestaltet, dass der Haupt-Schaltbalken HS erst ausgelenkt wird, wenn die Spannung am Eingangsanschluss 10 die zweite Schaltschwelle LP überschreitet.

Das Signal S liegt auf der Eingangsseite E an und geht von einer logischen Null in eine logische Eins über. Über die Schaltungsanordnung 1 wird dieser Signalwechsel zur Ausgangsseite A weitergeleitet, wobei mittels des mikroelektromechanischen Schalters MEMS zusätzlich eine galvanische Trennung zwischen der Eingangsseite E und der Ausgangsseite A herrscht. Das auf der Ausgangsseite A ausgegebene erkannte "Eins"-Signal wird über den Ausgangsanschluss 11 an eine Baugruppe CMOS zur Weiterverarbeitung weitergeleitet.

Die FIG 2 zeigt exemplarisch eine Aufteilung von Schaltschwellen. Bei Erreichen einer ersten Schaltschwelle LP wird eine logische Null ausgewertet. Bei Erreichen einer zweiten Schaltschwelle HP wird eine logische Eins ausgewertet. Beispielsweise könnte die erste Schaltschwelle LP bei 5 Volt liegen, so dass eine wirkliche logische Null "Low" erst bei Erreichen von 5 Volt erkannt wird. Im Hinblick auf eine spätere Drahtbruchprüfung ist dies von Vorteil, wenn gemäß FIG 7 über einen Geberkontakt GK das Signals S an den Eingangsanschluss 10 und parallel zum Geberkontakt GK ein Parallelwiderstand RP geschaltet ist, angelegt wird. Die Besonderheit bei dieser Art der Drahtbrucherkennung ist es, dass parallel zum Geberkontakt der Parallelwiderstand RP geschaltet ist, so dass auch bei geöffnetem Geberkontakt GK immer noch ein gewisser Strom in die Schaltungsanordnung 1 fließen kann und für eine Spannung knapp oberhalb der ersten Schaltschwelle LP sorgt. Wenn diese Spannung rund um die Schaltschwelle unter der Schaltschwelle LP in der Schaltungsanordnung 1 erkannt wird, kann man mit Sicherheit sagen, dass kein Drahtbruch vorliegt.

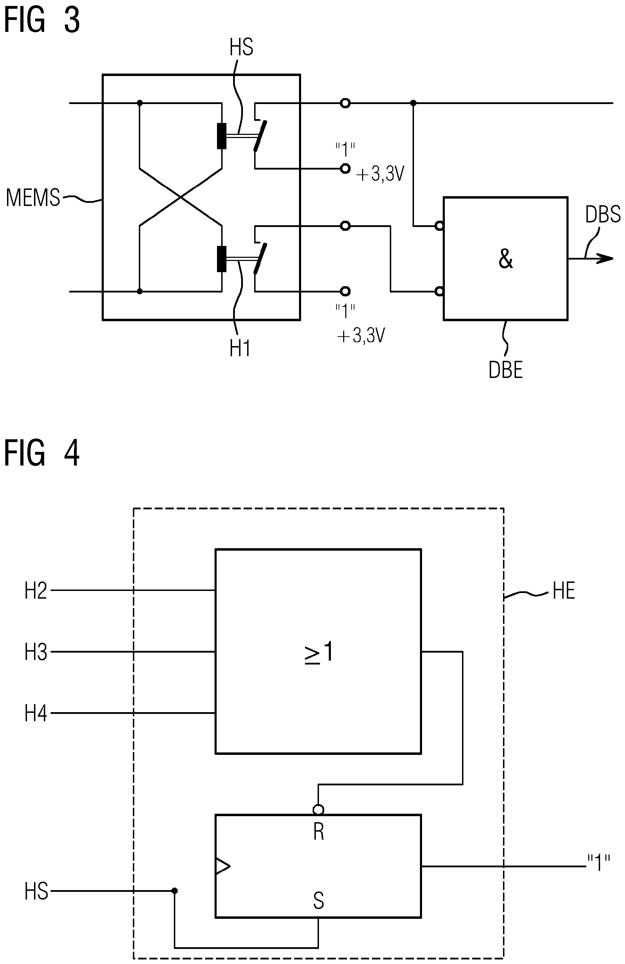

Mit der FIG 3 wird die Hinzunahme eines Hilfs-Schaltbalkens H1 zu dem Haupt-Schaltbalken HS erklärt. Der mikroelektromechanische Schalter MEMS ist demnach mit zumindest einen auslenkbar angeordneten ersten Hilfs-Schaltbalken H1 ausgestaltet, welcher hinsichtlich seiner Geometrie ausgestaltet ist, dass der erste Hilfs-Schaltbalken H1 bereits ausgelenkt wird, wenn die Spannung am Eingangsanschluss 10 die erste Schaltschwelle LP überschreitet.

Bei Vorherrschen eines logischen Eins Signals am Digitaleingang 10 werden demzufolge beide Schaltbalken, nämlich der Hilfs-Schaltbalken H1 und der Haupt-Schaltbalken HS geschlossen, welche wiederum ein logisches Eins Signal "1", beispielsweise in CMOS-Logik von + 3,3 Volt auf ein UND-Glied schalten. Für eine Drahtbruchauswertung über eine Drahtbrucherkennungseinheit DBE werden beide Signale negiert auf das UND-Glied gegeben. Sind beide Signale Eins, so wird ein Ausgang des UND-Gliedes ein Drahtbruchsignals DBS entsprechend Null erzeugen. Wenn weder der Haupt-Schaltbalken HS noch der Hilfs-Schaltbalken H1 ausgelenkt sind, wird am UND-Glied jeweils eine logische Null anliegen, welche zu einem Drahtbruchsignal DBS gleich Eins führt. D.h., wenn trotz dem zum Geberkontakt GK parallel geschalteten Parallelwiderstand RP der Hilfs-Schaltbalken H1 nicht ausgelenkt ist, so muss ein Drahtbruch vorliegen.

Gemäß FIG 4 wird eine weitere Funktionalität erklärt, nämlich eine Erkennung eines Hysterese-Verlaufs mittels einer Hysterese-Einheit HE. Die Hysterese-Einheit HE ist ausgestaltet, an einen Signalausgang solange eine logische Eins zu signalisieren, wie zumindest ein Hilfs-Schaltbalken H2,H3,H4 mit den zugeordneten Spannungswert, welcher die Schalt-Hysterese beschreibt, ausgelenkt ist. Der mikroelektromechanischen Schalter MEMS ist dazu mit einer Mehrzahl auslenkbarer angeordneter Hilfs-Schaltbalken H2,H3,H4 ausgestaltet, nämlich einem zweiten Hilfs-Schaltbalken H2, einem dritten Hilfs-Schaltbalken H3 und einem vierten Hilfs-Schaltbalken H4, welche entsprechend ihre Schaltsignale an ein ODER-Glied weitergeben. Die drei der Hysterese zugeordneten Signalwerte der drei Hilfs-Schaltbalken H2,H3,H4 sind ODER-verknüpft und das Ergebnis wird negiert und am Rücksetzeingang eines Flip-Flops gelegt. Das Signal des Haupt-Schaltbalkens HS ist auf einen Setzeingang S des Flip-Flops geschaltet.

Sollte das Signal des Haupt-Schaltbalkens HS kurzfristig wegfallen, so ist über die ODER-Verknüpfung immer noch ein Eins Signal auszuwerten, welches von den Signalen der Hilfs-Schaltbalken H2,H3,H4 kommt. Da dieses Signal negiert wird, wird das Flip-Flop nicht zurückgesetzt und ein "1" Signal bleibt am Ausgang erhalten.

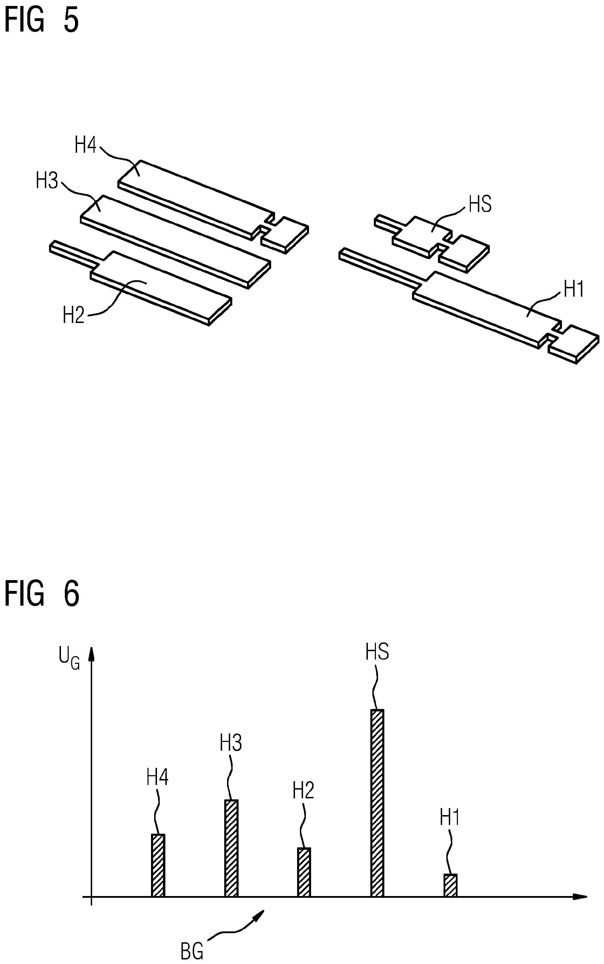

Gemäß FIG 5 sind für den Haupt-Schaltbalken HS und die entsprechenden Hilfs-Schaltbalken H1, H2, H3, H4 unterschiedliche Balkengeometrien dargestellt. Entsprechend zeigt die FIG 6 zu den unterschiedlichen Balkengeometrien eine minimale Spannung, welche am Gate eines MEMS-Schalters anliegen müsste damit die entsprechenden Schaltbalken schalten.

Bei FIG 6 ist die minimale Gate-Spannung UG über der Balkengeometrie BG aufgezeichnet.

Mit der FIG 7 wird gezeigt, wie ein elektronisches Gerät 30, ausgestaltet als eine digitale Eingabebaugruppe für ein Automatisierungsgerät mit der Schaltungsanordnung 1, ausgestaltet ist. Die Halbleiteranordnung Q weist eine eingangsstrombegrenzende Spannungsteiler-Halbleiteranordnung mit Dioden, Widerständen und Transistoren auf, zusätzlich gibt es einen Verpolschutz. An dem Eingangsanschluss 10 wird zusätzlich auch ein strombegrenzender Eingangswiderstand angeordnet, an dem wiederum der Geberkontakt GK mit seinen parallel geschalteten Parallelwiderstand RP angeschlossen ist. Das elektronische Gerät 30 verfügt über einen Masseanschluss M. Zwischen dem Eingangsanschluss 10 und dem Masseanschluss M ist ein Kondensator C1 angeordnet. Erfindungsgemäß ist nun auf einen oder anderweitig aufgebauten Schaltkreis 40 die Halbleiteranordnung Q zusammen mit dem mikroelektromechanischen Schalter MEMS aufgebaut. Wird der mikroelektromechanische Schalter MEMS ausgelenkt, so leitet er das auf der Eingangsseite E erkannte Signal S an die Ausgangsseite A weiter. Über den Ausgangsanschluss 11 kann es über eine CMOS-Einheit digital weiterverarbeitet werden.

Die mit FIG 3 erklärte Drahtbrucherkennungseinheit DBE liefert das Drahtbruchsignal DBS und ist in dem elektronischen Gerät 30 integriert.

Die mit FIG 4 erklärte Hysterese-Einheit HE ist ebenfalls in dem elektronischen Gerät 30 integriert und ist mit dem Ausgang derart verbunden, dass obwohl Spannungsschwankungen auf der Eingangsseite E herrschen, immer noch ein sicheres Eins Signal am Ausgangsanschluss A ausgegeben wird.

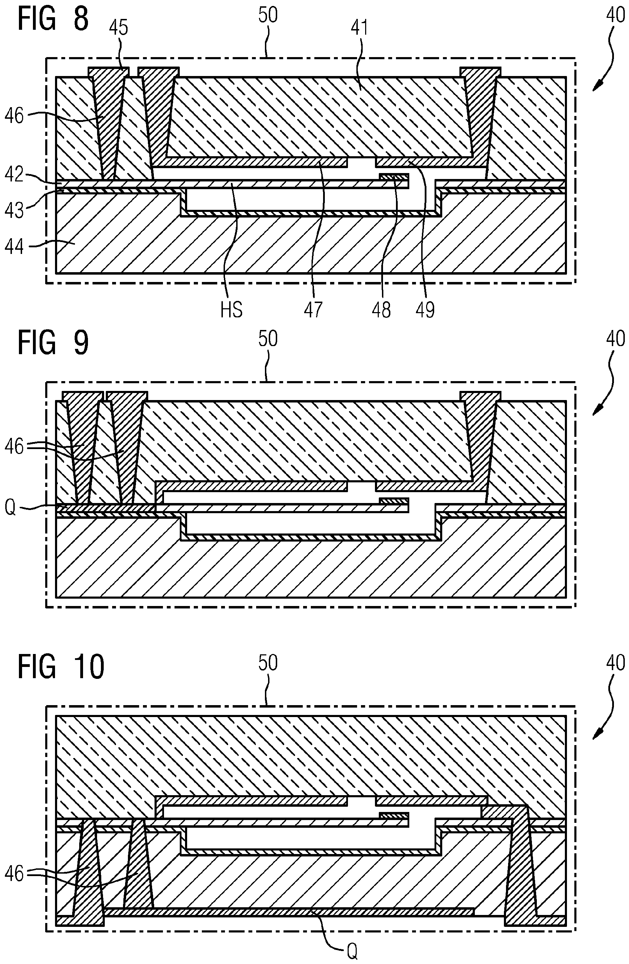

Die FIG 8 zeigt den schematischen Aufbau eines mikroelektromechanischen Schalters MEMS in einen hermetischen Gehäuse 50. In einem Glasdeckel-Wafer 41 sind Durchkontaktierungen 46 angeordnet, welche über ein Lötpad 45 elektrische Signale zu einer Schaltschicht 42 weiterleiten können. Die Schaltschicht 42 liegt auf einer Isolierschicht 43, wobei unter der Isolierschicht 43 eine Tragschicht 44 angeordnet ist. In der Schaltschicht 42 ist der Haupt-Schaltbalken HS realisiert. Der Haupt-Schaltbalken HS weist einen Schaltkontakt 48 auf. In dem Glasdeckel-Wafer 41 ist zum einen eine Gate-Elektrode 47 und ein Schaltkontakt 48 angeordnet.

Mit anderen Worten ist mit der FIG 8 ein MEMS-Schalter in einen hermetischen Package schematisch dargestellt. Über Durchkontaktierungen (Vias) im Glas, werden die elektrischen Signale zum Schaltelement übertragen. Auf der Außenseite kann das Bauteil dann über Lötpads auf einen Schaltungsträger gelötet werden. Um als digitaler Eingangsbaustein den unterschiedlichen Anwendungen zu dienen, ist es notwendig, dass die Schaltspannung der Schaltbalken eingestellt werden kann. Bei einen SOI-MEMS-Schalter ist dies durch eine Anpassung der Balkengeometrie innerhalb von weiten Grenzen möglich.

Dementsprechend ist der Haupt-Schaltbalken HS gemäß FIG 3 hinsichtlich seiner Geometrie derart ausgestaltet, dass der Haupt-Schaltbalken HS erst ausgelenkt wird, wenn die Spannung am Eingangsanschluss die zweite Schaltschwelle LH überschreitet.

Für eine Integration des mikroelektromechanischen Schalters MEMS und der Halbleiteranordnung Q stehen unterschiedliche Ansätze zur Verfügung, welche in den Figuren 9 bis 13 aufgezeigt werden.

FIG 9 zeigt eine erste Ausführungsvariante, welche eine monolithische Integration des mikroelektromechanischen Schalters MEMS und der Halbleiteranordnung Q direkt auf dem Silizium des MEMS-Schalters vorsieht. Die Halbleiteranordnung Q befindet sich dementsprechend in einem Device-Layer eines SOI-Wafers und Bauteile der Halbleiteranordnung Q können über die Durchkontaktierung 46, vorzugsweise Glas-Weyers kontaktiert werden.

Mit der FIG 10 wird ein Multichipmodul aufgezeigt. Bei diesen Modulen werden die beiden Teile, nämlich die Halbleiteranordnung Q und der mikroelektromechanische Schalter MEMS, jeweils auf eigenen Siliziumteilen realisiert und anschließend innerhalb eines Packages miteinander mechanisch und elektrisch verbunden. Die Halbleiteranordnung Q kann sich beispielsweise auf der Außenseite des mikroelektromechanischen Schalters MEMS befinden, die Kontaktierung geschieht mit Hilfe von Silizium-Vias.

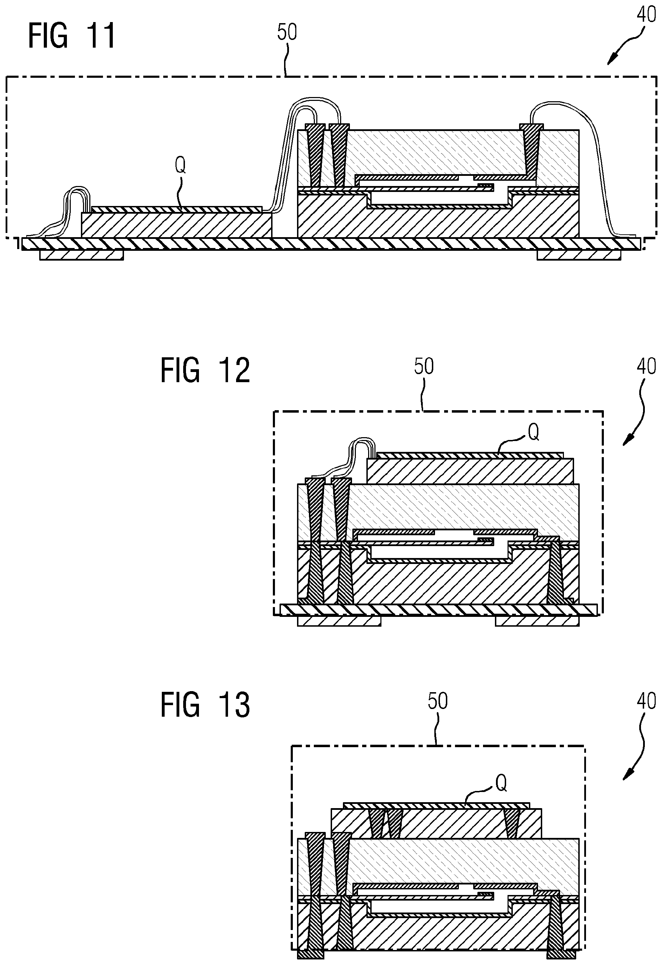

Die Figuren 11, 12 und 13 zeigen unterschiedliche Ausführungsvarianten für ein Multi-Chip-Modul eines mikroelektromechanischen Schalters MEMS mit einem analogen IC bzw. der Halbleiteranordnung Q.

FIG 11 zeigt, wie die Halbleiteranordnung Q auf dem Chip des mikroelektromechanischen Schalters MEMS untergebracht ist, die Kontaktierung erfolgen mittels Drahtbonds. Der gesamte Stapel wiederum befindet sich auf einem Interposer und wird von dem Gehäuse 50 umschlossen.

Gemäß FIG 12 und FIG 13 wird die Halbleiteranordnung Q bzw. der integrierte Schaltkreis direkt auf den Chip des mikroelektromechanischen Schalters MEMS montiert und wird mittels Silizium-Vias kontaktiert. Im Gegensatz zu der Ausführung gemäß FIG 11 wird kein Interposer verwendet, sondern der Stapel bildet sich direkt mit unterseitigen Lötpads und einer Umverdrahtungsebene auf der Chipseite des mikroelektromechanischen Schalters MEMS, welcher somit mit der Halbleiteranordnung verbunden werden kann. Z.B. wird ein Wafer Level Chip Scale package (WL-CSP) eingesetzt.

## Patentansprüche

1. Schaltungsanordnung (1) für einen Digitaleingang eines elektronischen Gerätes (30), umfassend
- einen als Digitaleingang fungierenden Eingangsanschluss (10) auf einer Eingangsseite (E),
- einen als Signalausgang fungierenden Ausgangsanschluss (11) auf einer Ausgangsseite (A),
- ein Schaltelement, welches ausgestaltet ist, ein auf der Eingangsseite (E) erkanntes Signal (S) an die Ausgangsseite (A) zur Weiterverarbeitung weiter zu leiten,
- einen Masseanschluss (M), wobei zwischen dem Eingangsanschluss (10) und dem Masseanschluss (M) eine Halbleiteranordnung (Q) zur Strombegrenzung eines Eingangsstroms (Iᵢₙ) für das Schaltelement angeordnet ist, wobei die Halbleiteranordnung (Q) zusätzlich ausgestaltet ist eine Höhe einer Spannung (U) des Signals an dem Eingangsanschluss (10) anhand einer ersten Schalschwelle (LP) als logisch Null zu werten und anhand einer zweiten Schaltschwelle (HP) als logisch Eins zu werten,
**dadurch gekennzeichnet, dass** das Schaltelement als ein mikroelektromechanischer Schalter (MEMS) mit einem auslenkbar angeordnetem Haupt-Schaltbalken (HS) ausgestaltet ist,
wobei der mikroelektromechanische Schalter (MEMS) hinsichtlich einer Geometrie des Haupt-Schaltbalkens (HS) ausgestaltet ist, dass der Haupt-Schaltbalken (HS) erst ausgelenkt wird, wenn die Spannung am Eingangsanschluss (10) die zweite Schaltschwelle (LH) überschreitet.

2. Schaltungsanordnung (1) nach Anspruch 1, wobei der mikroelektromechanische Schalter (MEMS) mit zumindest einem auslenkbar angeordnetem ersten Hilfs-Schaltbalken (H1) ausgestaltet ist, welcher hinsichtlich seiner Geometrie ausgestaltet ist, dass der erste Hilfs-Schaltbalken (H1) bereits ausgelenkt wird, wenn die Spannung am Eingangsanschluss (10) die erste Schaltschwelle (LP) überschreitet.

3. Schaltungsanordnung (1) nach Anspruch 2, wobei der mikroelektromechanische Schalter (MEMS) mit einer Mehrzahl auslenkbar angeordneter Hilfs-Schaltbalken (H1,H2,H3,H4) ausgestaltet ist und die Hilfs-Schaltbalken (H1,H2,H3,H4) hinsichtlich ihrer Geometrien derart ausgestaltet sind ,dass die Spannungswerte bei welchen die Hilfs-Schaltbalken (H1,H2,H3, H4) ausgelenkt werden, eine Schalt-Hysterese beschreiben, um Spannungsschwankungen der Spannung am Eingangsanschluss (10) zu unterdrücken, welche die zweite Schaltschwelle (HP) als logisch Eins betrifft.

4. Schaltungsanordnung (1) nach Anspruch 2 oder 3, aufweisend eine Drahtbrucherkennungseinheit (DBE), welche ausgestaltet ist, ein Drahtbruchsignal (DBS) zu erzeugen, wenn weder der Haupt-Schaltbalken (HS) noch der Hilfs-Schaltbalken (H1) ausgelenkt ist.

5. Schaltungsanordnung (1) nach einem der Ansprüche 2 bis 4, aufweisend eine Hysterese-Einheit (HE), welche ausgestaltet ist, dem Signalausgang solange logisch Eins zu signalisieren, wie zumindest ein Hilfs-Schaltbalken (H2,H3,H4) mit den zugeordneten Spannungswerten, welche die Schalt-Hysterese beschreiben, ausgelenkt ist.

6. Schaltungsanordnung (1) nach einem der Ansprüche 1 bis 5, wobei die Halbleiteranordnung (Q) und der mikroelektromechanische Schalter (MEMS) als ein monolithischer Schaltkreis (40) zusammengefasst sind.

7. Schaltungsanordnung (1) nach Anspruch 6, wobei der monolithische Schaltkreis (40) als ein hermetisch abgeschlossenes Gehäuse (50) ausgestaltet ist und der mikroelektromechanische Schalter (MEMS) aufgebaut ist mit
- einem Glasdeckel-Wafer (41),
- einer Schaltschicht (42) auf einer Isolierschicht (43), welche auf einer Tragschicht (44) liegt,
wobei die Schaltschicht (42) zumindest den Haupt-Schaltbalken (HS) aufweist, und die Halbleiteranordnung (Q) in das Gehäuse (50) integriert ist.

8. Elektronisches Gerät (30) ausgestaltet als eine digitale Eingabebaugruppe für ein Automatisierungsgerät mit einer Schaltungsanordnung (1) nach einem der Ansprüche 1 bis 7.

9. Elektronisches Gerät (30) ausgestaltet als eine digitale Eingabebaugruppe (30) für ein Automatisierungsgerät mit einer Schaltungsanordnung (1) nach Anspruch 4, wobei die Drahtbrucherkennungseinheit (DBE) derart konfiguriert ist, dass das Drahtbruchsignal (DBS) dadurch generiert wird, dass der Hilfs-Schaltbalken (H1) nicht ausgelenkt wird, und kein Drahtbruchsignal (DBS) generiert wird, wenn aufgrund eines Parallelwiderstandes (RP), welcher parallel zu einem Geberkontakt (GK) für das Signal (S) auf der Eingangsseite (E) geschaltet ist, der erste Hilfs-Schaltbalken (H1) ausgelenkt wird, wenn der Geberkontakt (GK) zwar geöffnet ist, aber die Spannung am Eingangsanschluss (10) durch den Parallelwiderstand (RP) die erste Schaltschwelle (LP) überschreitet.
